# EUROPEAN PATENT APPLICATION

(11) **EP 4 645 687 A1**
(43) Date of publication of application: **05.11.2025**
(21) Application number: 23920941.4
(22) Date of filing: 28.12.2023
(51) Int. Cl.: H03F 1/02

(54) **RADIO FREQUENCY POWER AMPLIFIER, AND METHOD FOR CONTROLLING DRAIN VOLTAGE OF RADIO FREQUENCY POWER AMPLIFIER**

(30) Priority: 06.02.2023 CN 202310127525
(71) Applicant: ZTE CORPORATION, Shenzhen, Guangdong 518057 (CN)
(72) Inventor: ZHANG, Bin, Shenzhen, Guangdong 518057 (CN); DU, Yonghong, Shenzhen, Guangdong 518057 (CN); WANG, Linguo, Shenzhen, Guangdong 518057 (CN); OUYANG, Yanhong, Shenzhen, Guangdong 518057 (CN); GAO, Xiaoguang, Shenzhen, Guangdong 518057 (CN)
(74) Representative: Ziebig Hengelhaupt Intellectual Property Attorneys Patentanwaltskanzlei PartGmbB
(86) International application number: PCT/CN2023/142691
(87) International publication number: WO 2024/164752

(57) **Abstract**

The present application belongs to the technical field of communications. Disclosed are a radio frequency power amplifier, and a method for controlling a drain voltage of a radio frequency power amplifier. The radio frequency power amplifier includes: a power supply unit, which is connected to a power amplifier unit and inputs a drain voltage to the power amplifier unit; and the power amplifier unit, which is used for amplifying an input radio frequency signal and outputting the amplified radio frequency signal, wherein the power supply unit determines a first output value of the drain voltage within a first time slot according to a first radio frequency output power of the power amplifier unit within a second time slot, adjusts the drain voltage to the first output value, and within the second time slot, maintains a voltage value of the drain voltage to be the first output value, the first time slot is a non-operating time slot of the radio frequency power amplifier, and the second time slot is an operating time slot, which is after the first time slot and adjacent to the first time slot, of the radio frequency power amplifier.

## Description

### CROSS REFERENCE TO RELATED APPLICATIONS

The present application is based upon and claims priority to Chinese Patent Application No. 202310127525.0, filed on February 06, 2023, entitled "RADIO FREQUENCY POWER AMPLIFIER, AND METHOD FOR CONTROLLING DRAIN VOLTAGE OF RADIO FREQUENCY POWER AMPLIFIER", the entire contents of which are incorporated herein by reference.

### TECHNICAL FIELD

Embodiments of the present application relate to the technical field of communications, in particular to a radio frequency power amplifier, and a method for controlling a drain voltage of a radio frequency power amplifier.

### BACKGROUD

Reducing power consumption of a radio frequency power amplifier (PA) is essential to reducing power consumption of a wireless communication base station. The service load of a wireless communication base station fluctuates widely according to time, and the wireless communication base station tends to a light load state. The wireless communication base station tends to adopt a linear power amplifier, and, the power amplifier in a critical saturation state achieves the highest efficiency upon the drain voltage of the power amplifier matches the output power thereof. However, in the related art, the power amplifier is supplied with direct current power, and the drain voltage of the power amplifier is set by referring to the maximum radio frequency output power, resulting in low efficiency and high power consumption of the power amplifier when the radio frequency output power of the power amplifier is relatively low.

### SUMMARY

The embodiments of the present application provide a radio frequency power amplifier, and a method for controlling a drain voltage of a radio frequency power amplifier, which can reduce the power consumption of a power amplifier.

In a first aspect, there is provided a radio frequency power amplifier, including: a power supply unit, which is connected to a power amplifier unit and inputs a drain voltage to the power amplifier unit; and the power amplifier unit, which is used for amplifying an input radio frequency signal and outputting an amplified radio frequency signal; wherein within a first time slot, the power supply unit determines a first output value of the drain voltage according to a first radio frequency output power of the power amplifier unit within a second time slot, and adjusts the drain voltage to the first output value; within the second time slot, the power supply unit maintains a voltage value of the drain voltage to be the first output value; the first time slot is a non-operating time slot of the radio frequency power amplifier, and the second time slot is an operating time slot, which is after the first time slot and adjacent to the first time slot, of the radio frequency power amplifier.

In a second aspect, there is provided a method for controlling a drain voltage of a radio frequency power amplifier, including: determining, according to a first radio frequency output power of a power amplifier unit of the radio frequency power amplifier within a second time slot, a first output value of a drain voltage input to the power amplifier unit within a first time slot, wherein the first time slot is a non-operating time slot of the radio frequency power amplifier, and the second time slot is an operating time slot, which is after the first time slot and adjacent to the first time slot, of the radio frequency power amplifier; and adjusting a drain voltage, which is input to the power amplifier unit by a power supply unit of the radio frequency power amplifier, to the first output value within the first time slot, and maintaining the drain voltage input to the power amplifier unit to be the first output value within the second time slot..

In a third aspect, there is provided a communication device, the communication device includes a processor and a memory, the memory stores a program or instruction that can run on the processor, and the program or instruction, when executed by the processor, implements the steps of the method of the second aspect.

In a fourth aspect, there is provided a computer-readable storage medium, the computer-readable storage medium stores at least one computer program, the computer program is loaded and executed by a processor to implement the steps of the method of the second aspect.

In a fifth aspect, there is provided a chip, the chip includes a processor and a communication interface, the communication interface is coupled to the processor, and the processor is used to execute a program or instruction so as to implement the steps of the method of the second aspect.

### BRIEF DESCRIPTION OF THE DRAWINGS

The accompanying drawings are incorporated herein and constitute a part of the specification, illustrating embodiments in accordance with the present application and used together with the specification to explain the principles of the present application.
FIG. 1 is a schematic structural diagram of an envelope tracking system in the related art.
FIG. 2 is a schematic structural diagram of a radio frequency power amplifier disclosed in embodiments of the present application.
FIG. 3 is a schematic principle diagram of a radio frequency power amplifier disclosed in embodiments of the present application.
FIG. 4 is a schematic principle diagram of a radio frequency power amplifier disclosed in embodiments of the present application.
FIG. 5 is a schematic principle diagram of a radio frequency power amplifier disclosed in embodiments of the present application.
FIG. 6 is another schematic structural diagram of a radio frequency power amplifier disclosed in embodiments of the present application.
FIG. 7 is another schematic principle diagram of a radio frequency power amplifier disclosed in embodiments of the present application.
FIG. 8 is a schematic flow chart of a method for controlling a drain voltage of a radio frequency power amplifier disclosed in embodiments of the present application.
FIG. 9 is a schematic structural diagram of a communication device disclosed in embodiments of the present application.

### DETAILED DESCRIPTION

Exemplary embodiments will be described in detail herein, examples of which are illustrated in the figures. When referring to the accompanying drawings, unless otherwise indicated, the same numbers in different drawings represent the same or similar elements. The implementations described in the following exemplary embodiments do not represent all implementations consistent with the present application. On the contrary, they are merely examples of devices and methods consistent with some aspects of the present application as described in the appended claims.

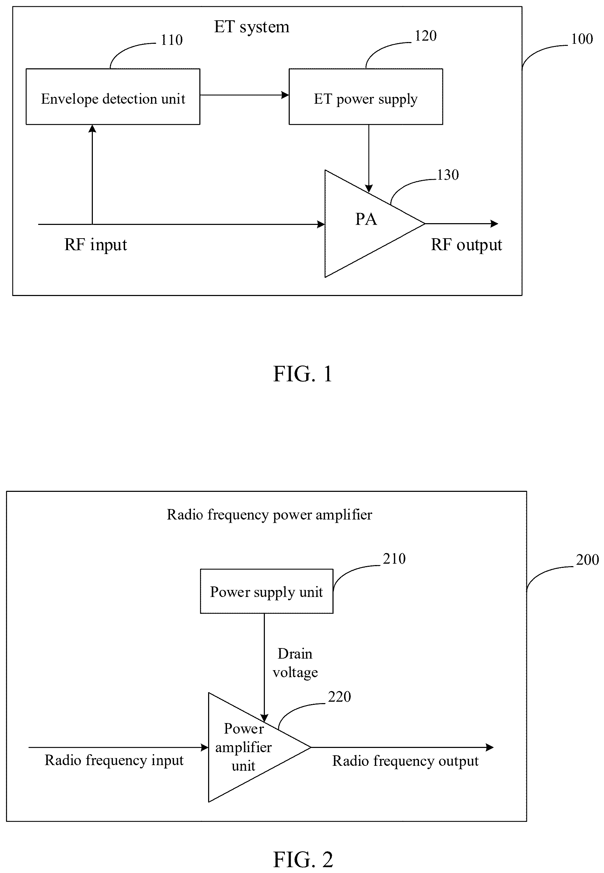

FIG. 1 shows an envelope tracking (ET) system 100 in the related art. In the ET system 100, an envelope detection unit 110 detects an envelope of a radio frequency (RF) input signal as a reference voltage of an ET power supply 120; the output of the ET power supply 120 is connected to a drain of a power amplifier (PA) 130, so as to provide the power amplifier 130 with a drain voltage that changes with the envelope. The ET technique can be used to reduce the loss of the power amplifier, especially in the case of a high peak to average power ratio (PAPR).

However, with the continuous evolution of wireless communication technology, the channel bandwidth and the signal PAPR are increasing, requiring the ET power supply to implement envelope signal tracking with wider bandwidth and amplitude, and thus reducing the feasibility of the ET power supply. Furthermore, since nonlinear characteristics of a radiofrequency power amplifier changes with the drain voltage, temperature, time, and etc., a wireless communication base station system needs to be provided with a digital pre-distortion (DPD) unit to realize high-linearity amplification, while the envelope tracking with wider bandwidth and amplitude makes the DPD is more difficult to realize. In addition, the ET power supply needs to be arranged close to a power amplifier so as to reduce the influence of electrical parasitic parameters (such as parasitic inductance, parasitic capacitance and parasitic resistance) of a power distribution network on the quality of a drain voltage signal of the power amplifier, causing that in a large-scale massive MIMO wireless communication base station system, the use of ET technique also brings out problems such as a large number of power supplies, high costs and large area.

Another related technique is symbol voltage adjustment, the principle of symbol voltage adjustment is similar to that of envelope tracking, but the voltage-adjustment time granularity of symbol voltage adjustment is larger than that of envelope tracking. The symbol voltage adjustment technique also has the technical problems and challenges of wide power supply voltage adjustment bandwidth, high voltage adjustment rate, large number of power supplies, high cost, large area, and the like.

In view of this, the present application provides a radio frequency power amplifier and a method for controlling a drain voltage of a radio frequency power amplifier.

FIG. 2 shows a structural schematic diagram of a radio frequency power amplifier provided by an exemplary embodiment of the present application, the radio frequency power amplifier 200 includes: a power supply unit 210, which is connected to a power amplifier unit 220 and inputs a drain voltage to the power amplifier unit 220; and the power amplifier unit 220, which is used for amplifying an input radio frequency signal and outputting an amplified radio frequency signal; wherein within a first time slot, the power supply unit 210 determines a first output value of the drain voltage according to a first radio frequency output power of the power amplifier unit 220 within a second time slot, and adjusts the drain voltage to the first output value, and within the second time slot, the power supply unit 210 maintains a voltage value of the drain voltage to be the first output value; the first time slot is a non-operating time slot of the radio frequency power amplifier, and the second time slot is an operating time slot, which is after the first time slot and adjacent to the first time slot, of the radio frequency power amplifier 200.

In the embodiment of the present application, the operating time slot refers to a time slot during which the radio frequency power amplifier 200 performs radio frequency power amplification. For example, when the radio frequency power amplifier 200 is applied to a base station so as to perform power amplification on a downlink signal, the operating time slot (i.e., the second time slot) refers to a downlink time slot, and the non-operating time slot (i.e., the first time slot) refers to an uplink time slot. When the radio frequency power amplifier 200 is applied to a terminal so as to perform power amplification on an uplink signal sent by the terminal, the operating time slot refers to an uplink time slot, and the non-operating time slot refers to a downlink time slot.

In the embodiment of the present application, the power supply unit is connected to the power amplifier unit and inputs the drain voltage to the power amplifier unit; and the power amplifier unit is used for amplifying the input radio frequency signal and outputting the amplified radio frequency signal; wherein within the first time slot, the power supply unit determines the first output value of the drain voltage according to the first radio frequency output power of the power amplifier unit within the second time slot, and adjusts the drain voltage to the first output value, within the second time slot, the power supply unit maintains the voltage value of the drain voltage to be the first output value; and the first time slot is a non-operating time slot of the radio frequency power amplifier, and the second time slot is an operating time slot, which is after the first time slot and adjacent to the first time slot, of the radio frequency power amplifier; thus, the power consumption of the power amplifier can be reduced.

In one embodiment, the non-operating time slot is greater than 100 microseconds. In this embodiment, the power supply unit can complete adjustment of drain voltage within relatively long time, and both the transient output power and device stress of the power supply unit are low, which can reduce the difficulty in implementing the power supply. Compared with related art such as envelope tracking, the difficulty in implementing the power supply unit can be reduced by means of the present embodiment.

In the embodiment of the present application, the power supply unit adjusts the drain voltage to the first output value within the non-operating time slot, and maintains the drain voltage to be the first output value within the operating time slot, so that the power consumption of the power amplifier can be reduced, and high power consumption caused by setting a drain voltage of the power amplifier with reference to the maximum radio frequency output power can be avoided. In addition, the drain voltage is maintained to be the first output value within the operating time slot, so that the difficulty in implementing the DPD technique can be reduced, a high-bandwidth power supply is not needed, a traditional power supply architecture is not changed, and the number, area and cost of the power supply unit are not increased.

In an embodiment of the present application, the radio frequency power amplifier 200 may be applied to a time division duplexing (TDD) system or a frequency division duplexing (FDD) system, for example, the non-operating time slot and the operating time slot of the radio frequency power amplifier 200 may be determined by symbol scheduling.

In an embodiment of the present application, there is further provided a communication device, the communication device includes an abovementioned radio frequency power amplifier. The communication device may be a wireless communication base station (also referred to as a base station) or a wireless terminal (also referred to as a terminal).

In one embodiment, the communication device may adopt a TDD mode. In this embodiment, upon the condition that the communication device is a wireless communication base station, the non-operating time slot is an uplink time slot, and the operating time slot is a downlink time slot; or upon the condition that the communication device is a wireless terminal, the non-operating time slot is a downlink time slot, and the operating time slot is an uplink time slot.

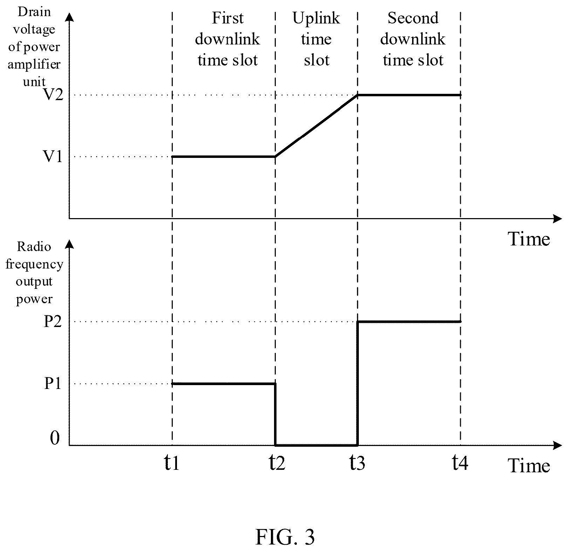

FIG. 3 shows a schematic principle diagram of a radio frequency power amplifier provided by the embodiment of FIG. 2. As shown in FIG. 3, the first time slot in the embodiment of FIG. 2 may be an uplink time slot, and the second time slot in the embodiment of FIG. 2 may be a second downlink time slot. The time period from t1 to t2 is a first downlink time slot of a wireless communication base station in a time division duplexing (TDD) mode, during which the radio frequency output power of the power amplifier unit 220 is P1, and the drain voltage of the power amplifier unit 220 is V1 and is kept unchanged; the time period from t2 to t3 is an uplink time slot, during which the power supply unit 210 adjusts the drain voltage output to the power amplifier unit 220 from V1 to V2; the time period from t3 to t4 is a second downlink time slot, during which the radio frequency output power of the power amplifier unit 220 is P2, and the drain voltage of the power amplifier unit 220 is V2 and is kept unchanged; and P1<P2, and V1<V2.

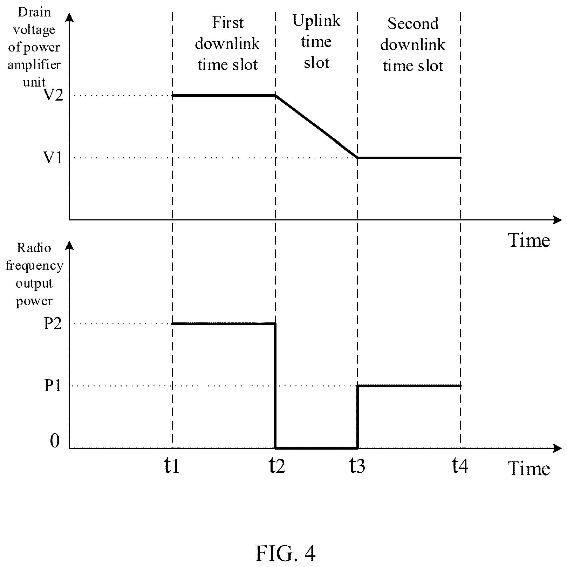

FIG. 4 shows another schematic principle diagram of a radio frequency power amplifier provided by the embodiment of FIG. 2. As shown in FIG. 4, the first time slot in the embodiment of FIG. 2 may be an uplink time slot, and the second time slot in the embodiment of FIG. 2 may be a second downlink time slot. The time period from t1 to t2 is a first downlink time slot of the wireless communication base station in the TDD mode, during which the radio frequency output power of the power amplifier unit 220 is P2, and the drain voltage of the power amplifier unit 220 is V2 and is kept unchanged; the time period from t2 to t3 is an uplink time slot, during which the power supply unit 210 adjusts the drain voltage output to the power amplifier unit 220 from V2 to V1; the time period from t3 to t4 is a second downlink time slot, during which the radio frequency output power of the power amplifier unit 220 is P1, and the drain voltage of the power amplifier unit 220 is V1 and is kept unchanged; and P1<P2, and V1<V2.

In one embodiment, the first output value is positively correlated with the first radio frequency output power.

The first output value is determined by the power supply unit 210 within the first time slot according to a first radio frequency output power of the power amplifier unit 220 within the second time slot. In the embodiment shown in FIG. 3, the first output value of the drain voltage increases from V1 to V2, then the first radio frequency output power increases from P1 to P2, that is, the first radio frequency output power increases with increase of the first output value of the drain voltage; and in the embodiment shown in FIG. 4, the first output value of the drain voltage decreases from V1 to V2, then the first radio frequency output power decreases from P2 to P1, that is, the first radio frequency output power decreases with decrease of the first output value of the drain voltage.

According to the embodiments shown in FIGS. 3 and 4, the working principle of an radio frequency power amplifier 200 proposed in the present application is illustrated. The drain voltage of the power amplifier is adjusted within the first time slot, so that the drain voltage of the power amplifier within the second time slot is positively correlated with the radio frequency output power of the power amplifier unit 220, which can reduce the power consumption of the power amplifier unit 220. In addition, since the drain voltage is kept unchanged within the second time slot, the difficulty in implementing the DPD technique is reduced.

In the embodiment of the present application, the power supply unit 210 is connected to the power amplifier unit 220 and inputs the drain voltage to the power amplifier unit 220; and the power amplifier unit 220 is used for amplifying the input radio frequency signal and outputting the amplified radio frequency signal; wherein within the first time slot, the power supply unit 210 determines the first output value of the drain voltage according to the first radio frequency output power of the power amplifier unit within the second time slot, and adjusts the drain voltage to the first output value; within the second time slot, the power supply unit 210 maintains the voltage value of the drain voltage to be the first output value; the first time slot is a non-operating time slot of the radio frequency power amplifier, and the second time slot is an operating time slot, which is after the first time slot and adjacent to the first time slot, of the radio frequency power amplifier. Therefore, the difficulty in implementing DPD technique can be reduced, a high-bandwidth power supply is not needed, the traditional power supply architecture is not changed, the number, area, and cost of power supply units are not increased, and the power consumption of a power amplifier of a wireless communication base station can be greatly reduced.

In one embodiment, the second time slot includes a plurality of symbols, the first output value is determined according to the first radio frequency output power of the power amplifier unit 220 within a first symbol, and the first symbol is a symbol corresponding to a maximum first radio frequency output power among the plurality of symbols.

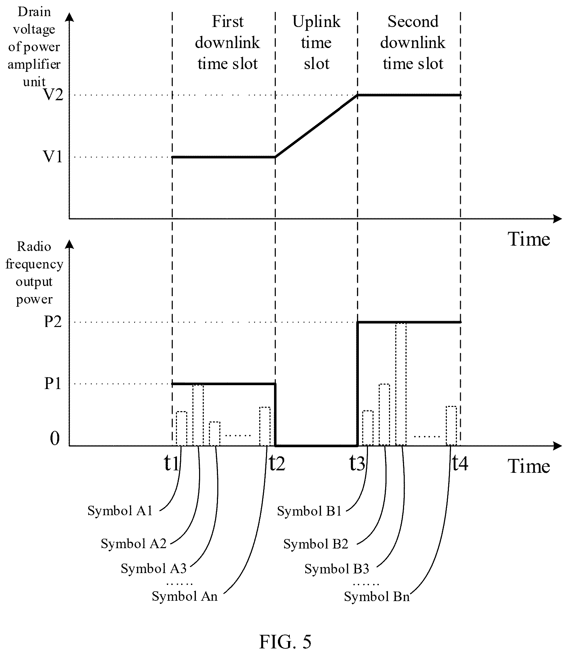

In some cases, as shown in FIG. 5, the first time slot may be an uplink time slot, and the second time slot may be a second downlink time slot. The second downlink time slot includes a plurality of symbols, i.e., symbol B1, symbol B2, symbol B3, ..., and symbol Bn in FIG. 5. The first radio frequency output power corresponding to the symbol B3 within the second downlink time slot is maximal and is P2, and the first output value of the drain voltage of the power amplifier unit 220 is set to V2, which corresponds to P2.

In one embodiment, the power supply unit 210 maintains a voltage value of the drain voltage to be a second output value within a third time slot, wherein the third time slot is an operating time slot which is prior to the first time slot and adjacent to the first time slot.

In another embodiment, the second output value is positively correlated with a second radio frequency output power of the power amplifier unit within the third time slot.

In yet another embodiment, the power supply unit 210 maintains a voltage value of the drain voltage to be a second output value within a third time slot, wherein the third time slot is an operating time slot which is before the first time slot and adjacent to the first time slot.

Referring to FIG. 5 again, the first time slot may be an uplink time slot, and the third time slot may be a first downlink time slot. The first downlink time slot includes a plurality of symbols, that is, symbol A1, symbol A2, symbol A3, ..., and symbol An in FIG. 5. The first radio frequency output power corresponding to symbol A2 within the first downlink time slot is the maximum and is P1, and the second output value of the drain voltage of the power amplifier unit 220 is set to V1, which corresponds to P1, i.e., the second output value is positively correlated with the second radio frequency output power of the power amplifier unit 220 within the third time slot.

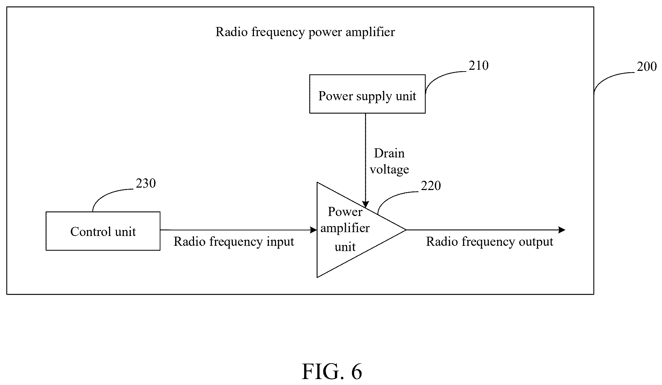

FIG. 6 shows another structural schematic diagram of a radio frequency power amplifier provided by an exemplary embodiment of the present application, the radio frequency power amplifier 200 further includes a control unit 230, which is used for scheduling target symbols in a plurality of target operating time slots into the same target operating time slot, wherein the target symbols are N symbols which correspond to the maximum radio frequency output powers of the plurality of target operating time slots respectively, and N is an integer greater than 0.

As shown in FIG. 6, the power supply unit 210 is connected to the power amplifier unit 220 and outputs a drain voltage thereto. The control unit 230 may adjust the sequence of different symbols in the first downlink time slot and the second downlink time slot, or adjust the sequence of different symbols in the first downlink time slot and a plurality of subsequent downlink time slots, so as to narrow the fluctuation range (peak to average ratio) of the radio frequency output power of the power amplifier unit 220 within each downlink time slot, and thus reduce the radio frequency output power of the power amplifier within a plurality of downlink time slots.

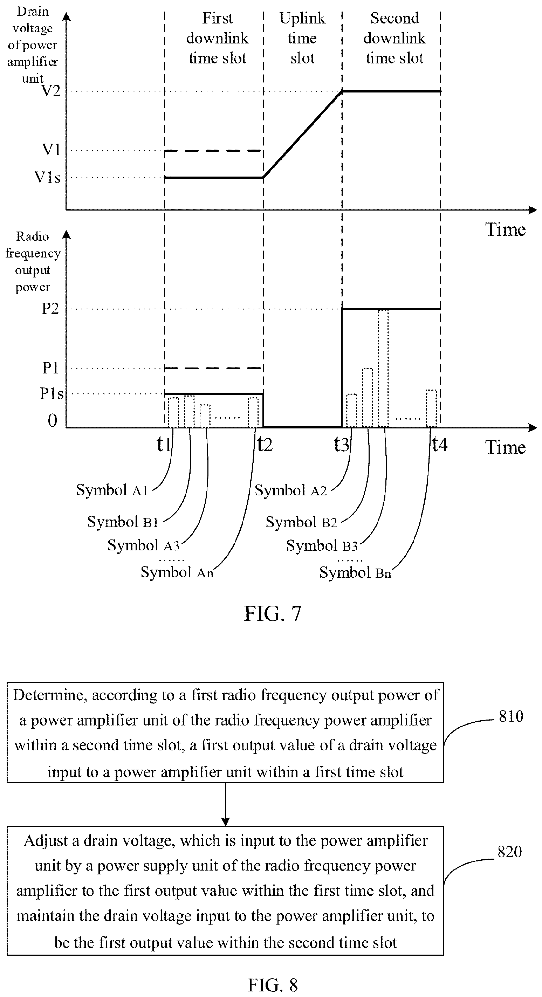

As shown in FIG. 7, the control unit 230 schedules the symbol A2 from the first downlink time slot into the second downlink time slot, and schedules the symbol B1 from the second downlink time slot into the first downlink time slot. The maximum transmission power of each symbol within the first downlink time slot after scheduling is recorded as P1s, and it is known that P1s<P1. After the symbol scheduling, within the first downlink time slot, i.e., the time period from t1 to t2, the drain voltage output by the power supply unit 210 to the power amplifier unit 220 is set to V1s and is kept unchanged within the first downlink time slot, and V1s<V1. Within the uplink time slot, i.e., the time period from t2 to t3, the power supply unit 210 starts and completes adjustment of the drain voltage output to the power amplifier unit 220, that is, the drain voltage is adjusted from V1s to V2. Within the second downlink time slot after the uplink time slot, i.e., the time period from t3 to t4, the drain voltage output by the power supply unit 210 to the power amplifier unit 220 is kept unchanged, and the drain voltage is positively correlated with the output power of the power amplifier unit 220 within the second downlink time slot.

In this embodiment, after symbol scheduling, the drain voltage within the first downlink time slot is reduced from V1 to V1s, which further reduces the loss of the power amplifier unit 220.

It should be noted that, upon the maximum radio frequency output power of the power amplifier within a single downlink time slot is reduced after symbol scheduling, the set value of the drain voltage of the power amplifier can be reduced accordingly, and thus the loss of the power amplifier unit 220 within the downlink time slot is reduced.

FIG. 8 illustrates a method for controlling a drain voltage of a radio frequency power amplifier provided in one embodiment of this application. The method can be executed by an electronic device, the electronic device may include a base station and/or a terminal device. In other words, the method can be executed by software or hardware installed in the electronic device, and the method includes the following steps 810 and 820.

At step 810: a first output value of a drain voltage input to a power amplifier unit 220 is determined within a first time slot according to a first radio frequency output power of the power amplifier unit 220 of the radio frequency power amplifier within a second time slot.

The first time slot is a non-operating time slot of the radio frequency power amplifier, and the second time slot is an operating time slot, which is after the first time slot and adjacent to the first time slot, of the radio frequency power amplifier.

In one embodiment, the non-operating time slot is greater than 100 microseconds. In this embodiment, the power supply unit can complete adjustment of drain voltage within relatively long time, and both the transient output power and device stress of the power supply unit are low, which can reduce the difficulty in implementing the power supply. Compared with related art such as envelope tracking, the difficulty in implementing the power supply unit can be reduced by means of the present embodiment.

In some cases, the step 810 may be performed by the radio frequency power amplifier 200 shown in FIG. 2, and the specific implementation may refer to description of embodiments of the radio frequency power amplifier described above, which will not be repeated herein.

At step 820: a drain voltage, which is input to the power amplifier unit 220 by a power supply unit 210 of the radio frequency power amplifier, is adjusted to the first output value within the first time slot, and the drain voltage input to the power amplifier unit 220 is maintained to be the first output value within the second time slot.

In some cases, the step 820 may be performed by the radio frequency power amplifier 200 shown in FIG. 2, the specific implementation may refer to description of embodiments of the radio frequency power amplifier described above, which will not be repeated herein.

In the embodiments of the present application, the first output value of the drain voltage input to the power amplifier unit 220 is determined within the first time slot according to the first radio frequency output power of the power amplifier unit 220 of the radio frequency power amplifier within the second time slot, wherein the first time slot is a non-operating time slot of the radio frequency power amplifier, and the second time slot is an operating time slot, which is after the first time slot and adjacent to the first time slot, of the radio frequency power amplifier; and the drain voltage, which is input to the power amplifier unit 220 by the power supply unit 210 of the radio frequency power amplifier, is adjusted to the first output value within the first time slot, and the drain voltage input to the power amplifier unit 220 is maintained to be the first output value within the second time slot. Therefore, the difficulty in implementing DPD technique can be reduced, a high-bandwidth power supply is not needed, the traditional power supply architecture is not changed, the number, area, and cost of power supply units are not increased, and the power consumption of a power amplifier of a wireless communication base station can be greatly reduced.

In one embodiment, the first output value is positively correlated with the first radio frequency output power.

In some cases, this embodiment may be performed by the radio frequency power amplifier 200 shown in FIG. 2, the specific implementation may refer to description of embodiments of the radio frequency power amplifier described above, which will not be repeated herein.

In one embodiment, that a first output value of a drain voltage input to a power amplifier unit 220 is determined within a first time slot according to a first radio frequency output power of the power amplifier unit 220 of the radio frequency power amplifier within a second time slot includes: the first output value of the drain voltage input to the power amplifier unit 220 is determined according to a first radio frequency output power of the power amplifier unit 220 within a first symbol, wherein the first symbol is a symbol corresponding to a maximum first radio frequency output power among a plurality of symbols.

In some cases, this embodiment may be performed by the radio frequency power amplifier 200 shown in FIG. 2, the specific implementation may refer to description of embodiments of the radio frequency power amplifier described above, which will not be repeated in detail here.

In one embodiment, the method for controlling a drain voltage of a radio frequency power amplifier further includes: a drain voltage, which is input to the power amplifier unit 220 by the power supply unit 210, is maintained to be a second output value within a third time slot, wherein the third time slot is an operating time slot which is prior to the first time slot and adjacent to the first time slot.

In some cases, this embodiment may be performed by the radio frequency power amplifier 200 shown in FIG. 2, the specific implementation may refer to description of embodiments of the radio frequency power amplifier described above, which will not be repeated in detail here.

In one embodiment, the second output value is positively correlated with a second radio frequency output power of the power amplifier unit 220 within the third time slot.

In some cases, this embodiment may be performed by the radio frequency power amplifier 200 shown in FIG. 2, the specific implementation may refer to description of embodiments of the radio frequency power amplifier described above, which will not be repeated in detail here.

In one embodiment, prior to that a drain voltage, which is input to the power amplifier unit 220 by the power supply unit 210, is maintained to be a second output value within a third time slot, the method for controlling a drain voltage of a radio frequency power amplifier further includes: the second output value is determined according to a second radio frequency output power of the power amplifier unit 220 within a second symbol, wherein the second symbol is a symbol corresponding to a maximum second radio frequency output power among a plurality of symbols comprised in the third time slot.

In some cases, this embodiment may be performed by the radio frequency power amplifier 200 shown in FIG. 2, the specific implementation may refer to description of embodiments of the radio frequency power amplifier described above, which will not be repeated in detail here.

In one embodiment, prior to that a first output value of a drain voltage input to a power amplifier unit 220 is determined within a first time slot according to a first radio frequency output power of the power amplifier unit 220 of the radio frequency power amplifier within a second time slot, the method for controlling a drain voltage of a radio frequency power amplifier further includes: target symbols in a plurality of target operating time slots are scheduled into the same target operating time slot, wherein the target symbols are N symbols which corresponds to the maximum radio frequency output powers of the plurality of target operating time slots respectively, and N is an integer greater than 0.

In some cases, this embodiment may be performed by the radio frequency power amplifier 200 shown in FIG. 6, the specific implementation may refer to description of embodiments of the radio frequency power amplifier described above, which will not be repeated in detail here.

In one embodiment, a non-operating time slot of the radio frequency power amplifier is determined by symbol scheduling.

In some cases, this embodiment may be performed by the radio frequency power amplifier 200 shown in FIG. 6, the specific implementation may refer to description of embodiments of the radio frequency power amplifier described above, which will not be repeated in detail here.

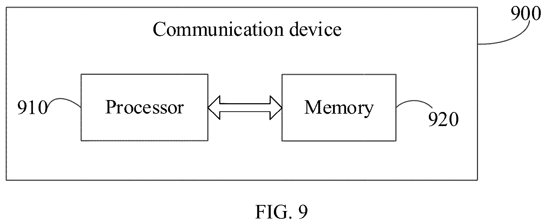

In one embodiment, as shown in FIG. 9, an embodiment of the present application further provides a communication device 900, including a processor 910 and a memory 920, the memory 920 stores a program or instruction executable on the processor 910, and the program or instruction, when executed by the processor 910, implements the various processes of embodiments of the method for controlling a drain voltage of a radio frequency power amplifier described above, and can achieve the same technical effect, to avoid repetition, it will not be repeated here.

An embodiment of the present application further provides a computer-readable storage medium storing a program or instruction thereon, and the program or instruction, when executed by the processor, implements the various processes of embodiments of the method for controlling a drain voltage of a radio frequency power amplifier described above, and can achieve the same technical effect, to avoid repetition, it will not be repeated here.

The processor is the processor in the communication device described in the above embodiment. The readable storage medium includes computer storage medium, such as read-only memory (ROM), random access memory (RAM), magnetic disk or optical disk, and the like.

An embodiment of the present application further provides a chip, the chip includes a processor and a communication interface, wherein the communication interface is coupled to the processor, and the processor is used to run programs or instructions, so as to implement the various processes of embodiments of the method for controlling a drain voltage of a radio frequency power amplifier described above, and can achieve the same technical effect, to avoid repetition, it will not be repeated here.

It should be understood that the chip mentioned in the embodiments of the present application can also be called a system-level chip, a system chip, a chip system or a system-on-chip, etc.

It should be noted that, as used herein, the terms "include", "comprise" or any other variations thereof are intended to cover a non-exclusive inclusion, such that a process, method, article, or apparatus that comprises a series of elements not only comprises those elements, but also comprises other elements that are not explicitly listed, or further comprises elements that are inherent to the process, method, article, or apparatus. Without further limitations, an element limited by "comprising a..." does not exclude the presence of other identical elements in the process, method, article, or device that comprises the element. In addition, it should be noted that the scope of the method and device in embodiments of this application is not limited to perform functions in the order shown or discussed, but may also include performing functions in a substantially simultaneous manner or in an opposite order according to the functions involved, for example, the described methods may be performed in a different order than described, and various steps may be added, omitted, or combined. Additionally, features described with reference to certain examples can be combined in other examples.

With the description of the above implementations, those skilled in the art can clearly understand that the above implementation methods can be effected via software and necessary general hardware platforms, as well as hardware, in many cases, the former is the preferred implementation. Based on such understanding, the technical solution of the this application essentially or the part contributing to the prior art may be embodied in the form of a software product, the computer software product is stored in a storage medium (such as a ROM/RAM, a magnetic disk, and an optical disk), and comprises a number of instructions for instructing a terminal (which may be a mobile phone, a computer, a server, an air conditioner, or a network device) to execute the methods described in various embodiments of this application.

The embodiments of the application are described above in conjunction with the accompanying drawings, but the application is not limited to the above-mentioned particular embodiments that are merely illustrative rather than limiting, a wide variety of forms can be made by a person skilled in the art under teachings of the application without departing from the spirit and scope of the application, and such forms all fall within the scope of the claims.

## Claims

1. A radio frequency power amplifier, comprising:
a power supply unit, which is connected to a power amplifier unit and inputs a drain voltage to the power amplifier unit; and
the power amplifier unit, which is used for amplifying an input radio frequency signal and outputting an amplified radio frequency signal;
wherein within a first time slot, the power supply unit determines a first output value of the drain voltage according to a first radio frequency output power of the power amplifier unit within a second time slot, and adjusts the drain voltage to the first output value; within the second time slot, the power supply unit maintains a voltage value of the drain voltage to be the first output value; the first time slot is a non-operating time slot of the radio frequency power amplifier, and the second time slot is an operating time slot, which is after the first time slot and adjacent to the first time slot, of the radio frequency power amplifier.

2. The radio frequency power amplifier according to claim 1, wherein the first output value is positively correlated with the first radio frequency output power.

3. The radio frequency power amplifier according to claim 2, wherein the second time slot comprises a plurality of symbols, the first output value is determined according to a first radio frequency output power of the power amplifier unit within a first symbol, and the first symbol is a symbol corresponding to a maximum first radio frequency output power among the plurality of symbols.

4. The radio frequency power amplifier according to claim 1, wherein the power supply unit maintains a voltage value of the drain voltage to be a second output value within a third time slot, wherein the third time slot is an operating time slot which is prior to the first time slot and adjacent to the first time slot.

5. The radio frequency power amplifier according to claim 3, wherein the second output value is positively correlated with a second radio frequency output power of the power amplifier unit within the third time slot.

6. The radio frequency power amplifier according to claim 5, wherein the third time slot comprises a plurality of symbols, the second output value is determined according to a second radio frequency output power of the power amplifier unit within a second symbol, and the second symbol is a symbol corresponding to a maximum second radio frequency output power among a plurality of symbols comprised in the third time slot.

7. The radio frequency power amplifier according to claim 1, wherein the non-operating time slot is greater than 100 microseconds.

8. The radio frequency power amplifier according to any one of claims 1 to 7, further comprising:
a control unit, which is used for scheduling target symbols in a plurality of target operating time slots into a same target operating time slot, wherein the target symbols are N symbols which correspond to maximum radio frequency output powers of the plurality of target operating time slots respectively, and N is an integer greater than 0.

9. The radio frequency power amplifier according to any one of claims 1 to 7, wherein a non-operating time slot of the radio frequency power amplifier is determined by symbol scheduling.

10. A communication device, comprising the radio frequency power amplifier according to any one of claims 1 to 9.

11. The communication device according to claim 10, wherein the communication device adopts a time division duplexing called TDD mode, upon the condition that the communication device is a wireless communication base station, the non-operating time slot is an uplink time slot, and the operating time slot is a downlink time slot; or upon the condition that the communication device is a wireless terminal, the non-operating time slot is a downlink time slot, and the operating time slot is an uplink time slot.

12. A method for controlling a drain voltage of a radio frequency power amplifier, comprising:
determining, according to a first radio frequency output power of a power amplifier unit of the radio frequency power amplifier within a second time slot, a first output value of a drain voltage input to the power amplifier unit within a first time slot, wherein the first time slot is a non-operating time slot of the radio frequency power amplifier, and the second time slot is an operating time slot, which is after the first time slot and adjacent to the first time slot, of the radio frequency power amplifier; and
adjusting a drain voltage, which is input to the power amplifier unit by a power supply unit of the radio frequency power amplifier, to the first output value within the first time slot, and maintaining the drain voltage input to the power amplifier unit to be the first output value within the second time slot.

13. The method according to claim 12, wherein the first output value is positively correlated with the first radio frequency output power.

14. The method according to claim 12, wherein determining, according to the first radio frequency output power of the power amplifier unit of the radio frequency power amplifier within the second time slot, the first output value of the drain voltage input to the power amplifier unit within the first time slot comprises:
determining, according to a first radio frequency output power of the power amplifier unit within a first symbol, the first output value of the drain voltage input to the power amplifier unit, wherein the first symbol is a symbol corresponding to a maximum first radio frequency output power among a plurality of symbols.

15. The method according to claim 14, wherein the method further comprises:
maintaining a drain voltage, which is input to the power amplifier unit by the power supply unit, to be a second output value within a third time slot, wherein the third time slot is an operating time slot which is prior to the first time slot and adjacent to the first time slot.

16. The method according to claim 15, wherein the second output value is positively correlated with a second radio frequency output power of the power amplifier unit within the third time slot.

17. The method according to claim 16, wherein prior to maintaining the drain voltage, which is input to the power amplifier unit by the power supply unit, to be the second output value within the third time slot, the method further comprises:
determining the second output value according to a second radio frequency output power of the power amplifier unit within a second symbol, wherein the second symbol is a symbol corresponding to a maximum second radio frequency output power among a plurality of symbols comprised in the third time slot.

18. The method according to claim 12, wherein the non-operating time slot is greater than 100 microseconds.

19. The method according to any one of claims 12 to 18, wherein prior to determining, according to the first radio frequency output power of the power amplifier unit of the radio frequency power amplifier within the second time slot, the first output value of the drain voltage input to the power amplifier unit within the first time slot, the method further comprises:
scheduling target symbols in a plurality of target operating time slots to a same target operating time slot, wherein the target symbols are N symbols which correspond to maximum radio frequency output powers of the plurality of target operating time slots respectively, and N is an integer greater than 0.

20. The method according to any one of claims 11 to 17, wherein a non-operating time slot of the radio frequency power amplifier is determined by symbol scheduling.

21. A communication device, comprising a processor and a memory, the memory stores a program or instruction that is executable on the processor, and the program or instruction, when executed by the processor, implements the steps of the method for controlling a drain voltage of a radio frequency power amplifier according to any one of claims 12 to 20.

22. A computer-readable storage medium, wherein the computer-readable storage medium stores at least one computer program, and the computer program is loaded and executed by a processor so as to implement the method for controlling a drain voltage of a radio frequency power amplifier according to any one of claims 12 to 20.
